(19) Europäisches Patentamt

European Patent Office

Office européen des brevets

(11) **EP 0 738 974 B1**

(12) **EUROPÄISCHE PATENTSCHRIFT**

(45) Veröffentlichungstag und Bekanntmachung des Hinweises auf die Patenterteilung:
**22.05.2002 Patentblatt 2002/21**

(51) Int Cl.[7]: **G06F 11/20**, G06F 11/00, G06F 11/10

(21) Anmeldenummer: **96104260.3**

(22) Anmeldetag: **15.03.1996**

(54) **Seriell zugreifbare Speichervorrichtung mit hoher Fehlerkorrigierbarkeit**

Serial access memory device with improved fault tolerance

Dispositif de mémoire à accès sériel avec tolérance de fautes améliorée

(84) Benannte Vertragsstaaten:
**AT DE FR GB IE IT NL**

(30) Priorität: **05.04.1995 DE 19512791**

(43) Veröffentlichungstag der Anmeldung:
**23.10.1996 Patentblatt 1996/43**

(73) Patentinhaber: **Infineon Technologies AG**
**81669 München (DE)**

(72) Erfinder:
• **Von Basse, Paul-Werner**
**82515 Wolfratshausen (DE)**
• **Bollu, Michael, Dr.**
**81671 München (DE)**
• **Thewes, Roland**
**82178 Puchheim (DE)**
• **Schmitt-Landsiedel, Doris, Dr.**
**85521 Ottobrunn (DE)**

(74) Vertreter:
**Patentanwaltskanzlei WILHELM & BECK**
**Nymphenburger Strasse 139**
**80636 München (DE)**

(56) Entgegenhaltungen:
**US-A- 3 812 336**

• **KIM K ET AL: "PERFECT LATIN SQUARES AND PARALLEL ARRAY ACCESS" COMPUTER ARCHITECTURE NEWS, Bd. 17, Nr. 3, Juni 1989, Seiten 372-379, XP000035323**

## Beschreibung

Bei seriellen Speichern mit matrixförmig angeordnetem Speicherfeld wird heute üblicherweise zunächst jeweils eine Zeile ausgewählt und anschließend jede einzelne Bitleitung sequentiell eingeschaltet, wodurch die Speicherinhalte einer Zeile ausgelesen bzw. überschrieben werden können. Bei Fehlern in Form von komplett ausfallenden Zeilen und/oder Spalten, die infolge der abhängigen Ausfallwahrscheinlichkeiten wesentlich häufiger vorkommen als zufällig über das gesamte Zellenfeld verteilte Fehler, ist eine Fehlerkorrektur nicht oder nur schlecht möglich. Das Problem der Fehlerkorrigierbarkeit bei vollständig ausfallenden Zeilen oder Spalten stellt sich besonders im Zusammenhang mit Nur-Lese-Speichern (ROMs), da ihr Speicherinhalt bereits während der Herstellung festgelegt wird und deshalb keine Ersatzzeilen oder Ersatzspalten vorgesehen werden können, wie dies beispielsweise bei Schreib-Lese-Speichern möglich ist.

Aus der europäischen Patentanmeldung EP 0 290 042 A2 ist eine Speichervorrichtung mit seriellem Zugriff bekannt mit einer Speichermatrix, deren Speicherzellen in M Zeilen und N Spalten angeordnet und mit Zeilenleitungen und Spaltenleitungen verbunden sind, mit einer Spaltenauswahleinrichtung, die mit den Spaltenleitungen verbunden ist und mit jedem Taktsignal zyklisch um eine Spalte weiterschaltet, und mit einer Zeilenauswahleinrichtung, die mit den Zeilenleitungen verbunden ist und mit einem Taktsignal um eine Zeile in der Zeilenauswahl weiterschreitet.

Durch eine Gatterschaltung in der Spaltenauswahleinrichtung wird hierbei die Anzahl der Schieberegisterstufen in der Spaltenauswahleinrichtung erniedrigt.

Aus dem IBM Technical Disclosure Bulletin, August 1984, Seiten 1756 und 1757 ist eine Umadressierung der Bits von Datenwörtern bekannt, um die Probleme bei der Korrektur von Spalten- bzw. Zeilenfehlern mittels redundanten Code zu behandeln.

Aus der amerikanischen Patentschrift US 47 03 453 ist die Tatsache bekannt, daß Speicherworte aus Speicherzellen zusammengesetzt werden, die nicht im Speicher benachbart liegen, sondern im Speicher verteilt angeordnet sind, um Probleme bei der Korrektur von Mehrfachfehlern zu beseitigen.

In der US 3,812,336 wird eine Adressenumwandlungseinrichtung für einen Speicher offenbart, die angebotene Speicheradressen derart umwandelt, daß Speicherworte mit unkorrigierbaren Fehlern in solche mit korrigierbaren Fehlern umgewandelt werden. Diese Modifizierung wird dabei so ausgeführt, daß die Adressendecodierer eine angebotene Adresse durch logische Schaltungen als Funktion von in einem Schieberegister gespeicherte Daten modifiziert. Für jede Bitposition ist dabei ein Schieberegister vorgesehen. Wenn mehrfach Fehler in einem Datenwort festgestellt werden, wird die in jedem Schieberegister gespeicherte Information dann derart verändert, daß die festgestellte Mehrfachfehlersituation aufgehoben wird. In den Schieberegistern werden verschiedene Galoisfeld-Zahlen gespeichert, wobei der Austausch der Bits zwischen den Worten als orthogonale Lateinquadrate erfolgt. Der Austausch kommt dadurch zustande, daß jedes Register mit Ausnahme des Schieberegisters der ersten Bitposition um eine Galoisfeld-Zahl weitergeschaltet wird, wenn eine Mehrfachfehlererkennung von der Fehlererkennungsschaltung festgestellt wird.

Die der Erfindung zugrundeliegende Aufgabe besteht nun darin, eine Speichervorrichtung mit seriellem Zugriff anzugeben, bei der entweder im Falle einer defekten Zeile oder im Falle einer defekten Spalte lediglich Fehler auftreten, die beispielsweise mit einem redundanten Code gut korrigierbar sind. Diese Aufgabe wird erfindungsgemäß durch die im Patentanspruch 1 angegebenen Merkmale gelöst.

Die Patentansprüche 2 und 5 betreffen vorteilhafte Ausgestaltungen der Erfindung.

Die Erfindung wird nachfolgend anhand der Zeichnungen näher erläutert. Dabei zeigt

Figur 1    ein Blockschaltbild einer erfindungsgemäßen Speichervorrichtung mit seriellem Zugriff,

Figur 2    eine Darstellung zur Erläuterung der Zugriffsreihenfolge mit jeweils zwei aufeinanderfolgenden Zellen einer gleichen Zeile,

Figur 3    eine weitere Darstellung zur Erläuterung der Zugriffsreihenfolge mit jeweils einer Zelle ohne eine unmittelbar folgende Zelle in einer gleichen Zeile,

Figur 4    eine andere Darstellung zur Erläuterung der Zugriffsreihenfolge mit jeweils einer Zelle ohne eine unmittelbar folgende Zelle in einer gleichen Zeile und Zeilen- und Spaltenschrittweiten größer als eins,

Figur 5    ein Blockschaltbild der Zeilenauswahleinrichtung von Figur 1 im Falle der Zugriffsreihenfolge von Figur 4 und

Figur 6    ein Blockschaltbild der Spaltenauswahleinrichtung der Speichervorrichtung von Figur 1 für den Fall der Zugriffsreihenfolge aus Figur 4.

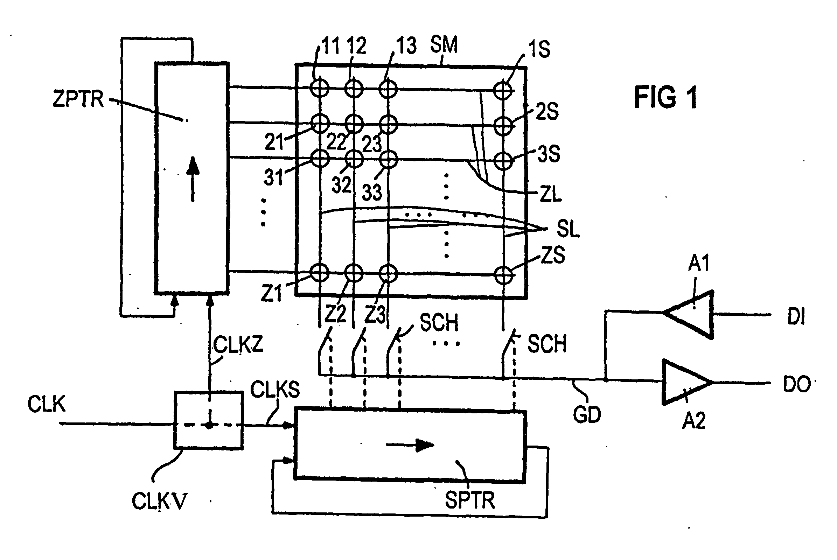

In Figur 1 ist eine erfindungsgemäße Speichervorrichtung mit seriellem Zugriff dargestellt, die eine Speichermatrix SM aufweist, deren Speicherzellen 11 ... ZS in Z Zeilen und S Spalten angeordnet sind und deren Speicherzellen jeweils mit Zeilenleitungen ZL und Spaltenleitungen SL verbunden sind. Darüber hinaus weist die erfindungsgemäße Speichervorrichtung eine Zeilenauswahleinrichtung ZPTR auf, die durch ein Zeilentaktsignal CLKZ angesteuert wird und deren Ausgänge mit den Zeilenleitungen verbunden sind. Ferner ist bei der Zeilenauswahleinrichtung ZPTR eine Signalrückführung eingezeichnet, die eine zyklische Auswahl der Zeilenleitungen ZL andeutet. Darüber hinaus weist die erfindungsgemäße Speichervorrichtung eine Spaltenauswahleinrichtung auf, die aus Schaltern SCH und einer Spaltenadressierungseinheit SPTR besteht, wobei für jede Spalte der Speichermatrix SM ein Schalter vorgesehen ist und jeder Schalter mit einem jeweiligen Ausgang der Spaltenadressierungseinheit SPTR verbunden ist. Die Spaltenadressierungseinheit SPTR wird durch Spaltentaktsignal CLKS angesteuert und eine eingezeichnete Signalrückführung deutet eine zyklische Adressierung an. Die Schalter SCH haben die Aufgabe, jeweils eine adressierte Spaltenleitung mit einer gemeinsamen Datenleitung GD zu verbinden. Durch einen vorhandenen Eingangsverstärker A1 werden externe Eingangsdaten DI verstärkt und auf die gemeinsame Datenleitung GD aufgeschaltet und durch einen Ausgangsverstärker A2 werden auf der gemeinsamen Datenleitung anstehende Ausgangsdaten verstärkt bevor sie als externe Ausgangsdaten DO zur Verfügung stehen. Das Zeilentaktsignal CLKZ und das Spaltentaktsignal CLKS werden in einer Spaltenverknüpfungsschaltung CLKV aus einem externen Taktsignal CLK gebildet. Die Spaltenverknüpfungsschaltung CLKV besteht beispielsweise aus zwei Frequenzteilerschaltungen auf der Basis von Flip-Flops. Im einfachsten Fall ist sowohl das Zeilentaktsignal als auch das Spaltentaktsignal gleich dem externen Taktsignal CLK und die Schaltung CLKV besteht lediglich, wie in Figur 1 mit gestrichelten Linien angedeutet ist, aus Verbindungen zum externen Taktsignal.

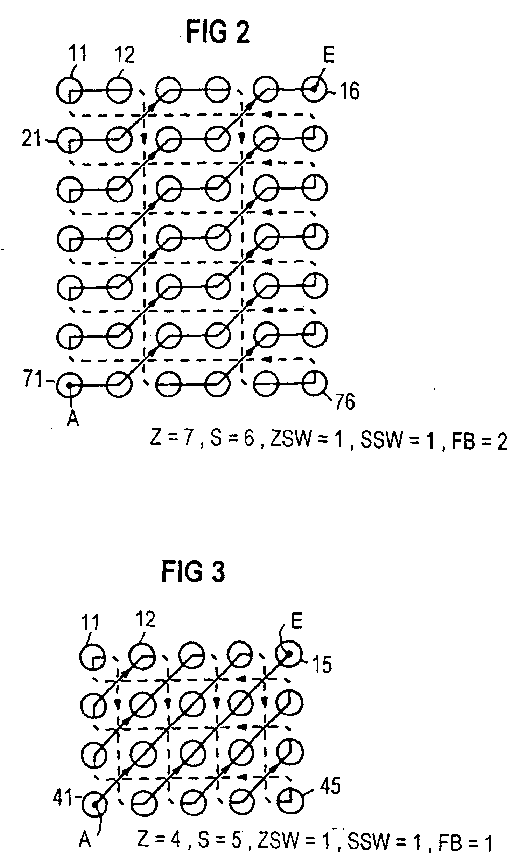

In Figur 2 ist beispielhaft eine Speichermatrix SM mit Z= 7 Zeilen und S=6 Spalten mit den Speicherzellen 11 ... 76 vereinfacht dargestellt, wobei die Speicherzelle 71 als Anfangszelle A gewählt wurde und damit die Speicherzelle 16 die Endzelle E bildet und wobei die Speicherzellen nach der Art einer Matrixindizierung benannt sind. Hierbei erfolgt jeweils nach FB = 2 aufeinanderfolgenden Spalten zusätzlich zu einem Spaltenwechsel auch ein Zeilenwechsel, wobei jeweils von der sechsten Spalte ein Übergang wieder zurück in die erste Spalte erfolgt. Die Zugriffsreihenfolge innerhalb der physikalischen Grenzen des zellenfeldes der Speichermatrix SM ist mit Hilfe von durchgezogenen Linien und die Übergänge über die physikalischen Grenzen des Zellenfeldes hinaus sind mit gestrichelten Linien angedeutet.

Bei jedem Übergang zu einer weiteren Speicherzelle wird entweder gar nicht oder nur auf die unmittelbar nächste Zeile sowie nur auf die unmittelbar nächste Spalte weitergeschaltet, d. h. sowohl die Zeilensprungweite ZSW als auch die Spaltensprungweite SSW beträgt hier jeweils eins.

Mit der in Figur 2 dargestellten Zugriffsreihenfolge treten, wenn maximal alle Zellen einer Zeile defekt sind, lediglich maximal zwei fehlerhafte Bits in je einem von S/FB = 3 ausgelesenen Blöcken zu je Z*FB = 14 Zellen auf. Der erste auszulesende Block besteht hier aus den Zellen 71, 72, 63, 64, 55, 56, 41, 42, 33, 34, 25, 26, 11, 12.

Eine Zugriffsreihenfolge mit FB=2 ist durch eine Anordnung nach Figur 1 erzielbar, wenn als Zeilenauswahleinrichtung und Spaltenauswahleinrichtung zyklische Schieberegister verwendet werden, das Taktverhältnis CLKZ/CLKS = 0,5 beträgt und die Bedingungen S MOD FB = 0 und GGT(Z,S/FB)=1 hinsichtlich der Speicherdimensionierung eingehalten werden, wobei GGT den größten gemeinsamen Teiler und MOD die Modulo-Funktion bedeuten.

Werden die Bedingungen nicht erfüllt sind zusätzliche Umschalteinrichtungen in den Zeilen- und Spaltenauswahleinrichtungen erforderlich, die für sich nicht in einfacher Weise für alle Speicherdimensionierungen allgemein angebbar, für den konkreten Einzelfall jedoch relativ leicht zu entwickeln sind.

In Figur 3 ist beispielhaft eine Speichermatrix SM mit Z= 4 Zeilen und S=5 Spalten mit den Speicherzellen 11 ... 45 vereinfacht dargestellt, wobei die Speicherzelle 41 als Anfangszelle A gewählt wurde und damit die Speicherzelle 15 die Endzelle E bildet und wobei die Speicherzellen nach der Art einer Matrixindizierung benannt sind. Hierbei erfolgt jeweils nach FB = 1 aufeinanderfolgenden Spalten zusätzlich zu einem Spaltenwechsel auch ein Zeilenwechsel, wobei jeweils von der fünften Spalte ein Übergang wieder zurück in die erste Spalte erfolgt. Die Zugriffsreihenfolge innerhalb der physikalischen Grenzen des Zellenfeldes der Speichermatrix SM ist mit Hilfe von durchgezogenen Linien und die Übergänge über die physikalischen Grenzen des Zellenfeldes hinaus sind mit gestrichelten Linien angedeutet.

Bei jedem Übergang zu einer weiteren Speicherzelle wird nur auf die unmittelbar nächste Zeile sowie nur auf die unmittelbar nächste Spalte weitergeschaltet, d. h. sowohl die Zeilensprungweite ZSW als auch die Spaltensprungweite SSW beträgt hier jeweils eins.

Mit der in Figur 3 dargestellten Zugriffsreihenfolge tritt, wenn maximal alle Zellen einer Zeile defekt sind, lediglich maximal ein fehlerhaftes Bit in je einem von S/FB = 5 ausgelesenen Blöcken zu je Z*FB = 4 Zellen auf. Der erste auszulesende Block besteht hier aus den Zellen 41, 32, 23, 14.

Eine Zugriffsreihenfolge mit FB=1 ist durch eine Anordnung nach Figur 1 erzielbar, wenn als Zeilenauswahleinrichtung und Spaltenauswahleinrichtung zyklische Schieberegister verwendet werden und das Taktverhältnis CLKZ/CLKS = 1 beträgt und die Bedingung GGT(Z,S)=1 hinsichtlich der Speicherdimensionierung eingehalten wird.

Da im Fehlerfall die fehlerhaften Zellen häufig nicht nur in einer Zeile und/oder Spalte konzentriert sind, sondern auch Nachbarzeilen und/oder Nachbarspalten betroffen sind, kann es unter Umständen von Vorteil sein die Zeilensprungweite und/oder die Spaltensprungweite verschieden von eins zu wählen.

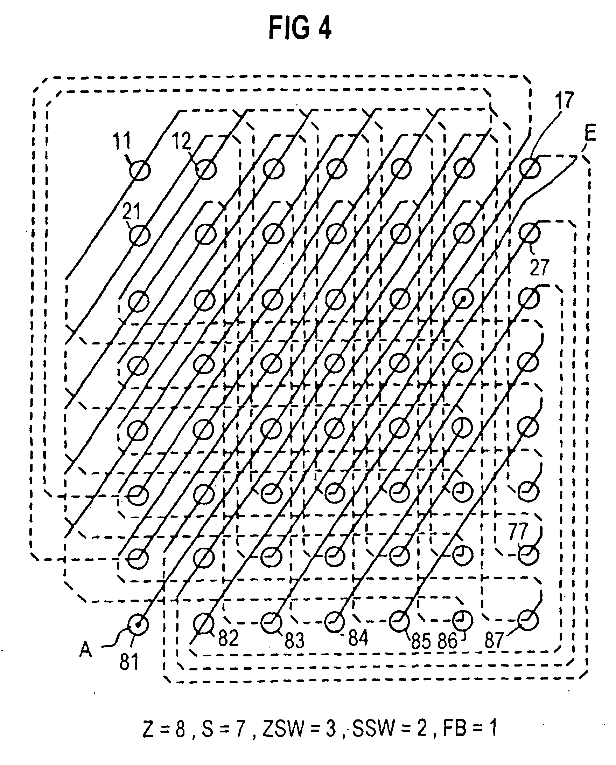

In Figur 4 ist beispielhaft eine Speichermatrix mit den Speicherzellen 11 ... 87 mit acht Zeilen und sieben Spalten dargestellt, wobei die Zelle 81 die Anfangszelle A gewählt wurde und damit die Zelle 36 die Endzelle E darstellt und wobei die Speicherzellen wie bei einer üblichen Matrixindizierung benannt sind. Die Zeilensprungweite ZSW beträgt in diesem Fall drei und die Spaltensprungweite SSW zwei. Die Speicherzellen sind beginnend mit A und endend mit E in der Reihenfolge des Zugriffs miteinander durch einen Graph verbunden, wobei die Übergänge über den Rand des physikalischen Rand durch gestrichelte Linien und alle anderen Übergänge durch durchgezogene Linien dargestellt sind. Die Speicherzellen werden dabei in der nachfolgend angegebenen Reihenfolge adressiert.

81, 53, 25, 77, 42, 14, 66,
31, 83, 55, 27, 72, 44, 16,
61, 33, 85, 57, 22, 74, 46,
11, 63, 35, 87, 52, 24, 76,
41, 13, 65, 37, 82, 54, 26,
71, 43, 15, 67, 32, 84, 56,
21, 73, 45, 17, 62, 34, 86,
51, 23, 75, 47, 12, 64, 36.

Damit alle Speicherzellen der Speichermatrix mit Z*S Zugriffen adressiert werden, müssen entweder zusätzliche Vorkehrungen in den Zeilen- und Spaltenauswahlschaltungen getroffen werden, die Zeilen-oder Spaltenumschaltungen vornehmen, wenn jeweils die letzte Spalte oder letzte Zeile erreicht ist, oder müssen im Fall FB=1 vorteilhafterweise nur die Zeilenzahl Z und die Spaltenzahl S der Speichermatrix SM und auch die Zeilensprungweite ZSW und die Spaltensprungweite SSW so vorgesehen werden, daß die beiden folgenden Bedingungen

$$GGT(S,SSW) = 1$$

und

$$GGT(Z, (S*ZSW) \bmod Z ) = GGT(Z,S*ZSW) = 1$$

erfüllt sind, wobei GGT() den größten gemeinsamen Teiler und MOD die Modulo-Operation bedeuten.

Für die im Beispiel von Figur 3 dargestellte Speichermatrix und die jeweiligen Sprungweiten ist GGT(5,1) = 1 und GGT(4, (5*1) MOD 4) = 1.

Für das in Figur 4 gezeigte Beispiel ist die Bedingung GGT(7,2) = 1 und die Bedingung GGT(8,(7*3) MOD 8) = GGT(8, (21 MOD 8)) = GGT(8,5) = 1 erfüllt.

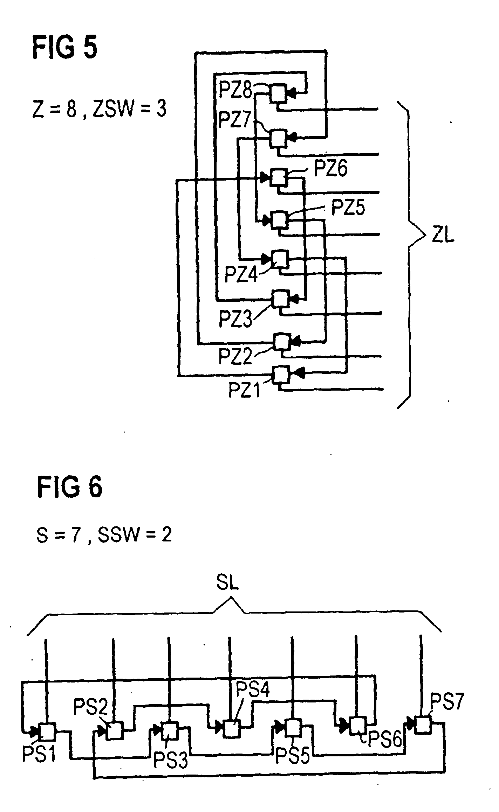

Für das in Figur 4 gezeigte Beispiel ist in Figur 5 eine Blockschaltung einer Zeilenauswahleinrichtung ZPTR für acht Zeilen und einer Zeilensprungweite ZSW = 3 in Form eines zyklisch geschalteten Schieberegisters mit den Registerstufen PZ1 ... PZ8 dargestellt. Die Schieberegister PZ1 ... PZ8 sind dabei der Reihe nach den Zeilenleitungen ZL für die Zeilen 1 bis 8 zugeordnet. Ausgehend von einem Zustand PZ8 = 1 und PZ7 ... PZ1 = 0 bzw. von einem Zustand PZ8 = 0 und PZ7 ... PZ1 = 1 wird synchron zu einem Taktsignal CLK der Inhalt der Zelle PZ8 in die Zelle PZ5 übertragen. Es folgen hierauf, jeweils synchron mit dem Taktsignal CLK, nacheinander in der angegebenen Reihenfolge die Überträge in die Zelle PZ2, in die Zelle PZ7, in die Zelle PZ4, in die Zelle PZ1, in die Zelle PZ6 und in die Zelle PZ3, bevor der Übertrag in die Ausgangszelle PZ8 erfolgt. Diese Übergänge sind in Figur 5 jeweils als Pfeile dargestellt.

In Figur 6 ist eine entsprechende Spaltenadressierungseinheit SPTR dargestellt, die die Schalter. SCH für die jeweiligen Spaltenleitungen ansteuert. Wie in Figur 4 ist die Spaltenadressierungseinheit beispielhaft für sieben Spalten und eine Spaltensprungweite SSW = 2 ausgelegt. Die Spaltenadressierungseinheit besteht aus einem Schieberegister mit sieben zyklisch geschalteten Schieberegisterstufen PS1 ... PS7. Beginnend mit einem Ausgangszustand PS1 = 1 und PS2 ... PS7 = 0 bzw. mit einem Ausgangszustand PS1 = 0 und PS2 ... PS7 = 1 erfolgt abhängig von einem Taktsignal CLK ein erster Informationsübertrag von der Schieberegisterstufe PS1 auf die Schieberegisterstufe PS3 und dann der Reihenfolge nach auf die Schieberegisterstufen PS5, PS7, PS2, PS4 und PS6 bevor ein Übertrag zurück zur Schieberegisterstufe PS1 erfolgt. Die Ausgänge der Registerstufen PS1 ... PS7 sind der Reihe nach den Spaltenleitungen SL für die Spalten 1 ... 7 zugeordnet.

Die gesamte Speichervorrichtung kann dabei auch um 90° gedreht werden, das heißt daß die Zeilen und Spalten sowie die Zeilensprungweite und die Spaltensprungweite miteinander vertauscht sind.

**Patentansprüche**

1. Speichervorrichtung mit seriellem Zugriff,

   - mit einer Speichermatrix (SM), deren Speicherzellen (11...ZS) in Z Zeilen und S Spalten angeordnet und mit Zeilenleitungen (ZL) und Spaltenleitungen (SL) verbunden sind,

   - mit in einer Taktverknüpfungseinheit (CLKV), die aus einem externen Taktsignal (CLK) ein Zeilentaktsignal (CLKZ) und ein Spaltentaktsignal (CLKS) bildet,

   - mit einer Zeilenauswahleinrichtung (ZPTR), die mit den Zeilenleitungen verbunden ist und mit jedem Zeilentaktsignal (CLKZ) zyklisch um eine vorgegebene Zeilensprungweite ZSW in der Zeilenauswahl weiterschaltet,

- mit einer Spaltenauswahleinrichtung (SPTR, SCH), die mit den Spaltenleitungen verbunden ist und mit jedem Spaltentaktsignal (CLKS) zyklisch um eine vorgegebene Spaltensprungweite (SSW) in der Spaltenauswahl weiterschaltet, und

- bei der die Zeilenauswahleinrichtung und die Spaltenauswahleinrichtung derart ausgebildet sind, daß bereits jeweils eine neue Zeile ausgewählt wird nachdem n Spalten ausgewählt wurden und/oder bereits jeweils eine neue Spalte ausgewählt wird nachdem m Zeilen ausgewählt wurden, wobei n kleiner als S und m kleiner als Z ist und die größere Zahl der beiden Zahlen n und m die Anzahl der noch durch einen Code korrigierbaren Bits in einem Speicherwort darstellt.

2. Speichervorrichtung nach Anspruch 1,

- bei der sowohl die Zeilenauswahleinrichtung (ZPTR) als auch die Spaltenauswahleinrichtung (SPTR, SCH) zu einem Ring geschaltete Schieberegister ( z. B. PZ1..PZ8 bzw. PS1.. PS7) aufweisen, in denen jeweils entweder eine einzige logische Eins oder eine einzige logische Null zyklisch weitergeschoben werden,

- bei der das Zeilentaktsignal und das Spaltentaktsignal derart gebildet ist, daß das Taktverhältnis Zeilentakt zu Spaltentakt größer als 1 durch S und/oder kleiner als Z ist,

- bei der die Zeilenauswahleinrichtung (ZPTR) synchron mit dem Zeilentaktsignal (CLKZ) weitergeschaltet wird und

- bei der die Spaltenauswahleinrichtung (SPTR, SCH) synchron mit dem Spaltentaktsignal (CLKS) weitergeschaltet wird.

3. Speichervorrichtung nach Anspruch 2, bei der sowohl das Zeilentaktsignal (CLKZ) und das Spaltentaktsignal (CLKS) gleich dem externen Taktsignal (CLK) sind.

4. Speichervorrichtung nach Anspruch 3,

- bei der die Zeilenauswahleinrichtung (ZPTR) und die Spaltenauswahleinrichtung (SPTR, SCH) derart ausgestaltet sind, daß mit jedem Spaltenwechsel gleichzeitig auch immer ein Zeilenwechsel erfolgt,

- bei der die Zeilenzahl Z und die Spaltenzahl S der Speichermatrix (SM ), die Zeilensprungweite (ZSW) und die Spaltensprungweite

(SSW) die Bedingungen

$$GGT(S,SSW) = 1$$

und

$$GGT(Z,(S*ZSW) \bmod Z ) = 1$$

erfüllen, wobei GGT den größten gemeinsamen Teiler und MOD die Modulo-Operation bedeuten.

5. Speichervorrichtung nach einem oder mehreren der Ansprüche 2 bis 4, bei der die einzelnen Schieberegister den Zeilenleitungen und Spaltenleitungen so zugeordnet sind, daß dadurch in der Zeilen- und Spaltenauswahl eine gewünschte Zeilensprungweite (ZSW) und eine gewünschte Spaltensprungweite (SSW) bewirkt werden.

**Claims**

1. Memory device with serial access,

- having a memory matrix (SM), whose memory cells (11...ZS) are arranged in Z rows and S columns and are connected to row lines (ZL) and column lines (SL),

- having a clock combination unit (CLKV) which forms a row clock signal (CLKZ) and a column clock signal (CLKS) from an external clock signal (CLK),

- having a row selection device (ZPTR), which is connected to the row lines and, with each row clock signal (CLKZ), cyclically advances by a predetermined row jump increment ZSW in the row selection,

- having a column selection device (SPTR, SCH), which is connected to the column lines and, with each column clock signal (CLKS), cyclically advances by a predetermined column jump increment (SSW) in the column selection, and

- in which the row selection device and the column selection device are designed in such a way that in each case a new row is already selected after n columns have been selected and/or in each case a new column is already selected after m rows have been selected, where n is less than S and m is less than Z and the larger number of the two numbers n and m represents the number of bits that can still be corrected by a code in a memory word.

2. Memory device according to Claim 1,

   - in which both the row selection device (ZPTR) and the column selection device (SPTR, SCH) have shift registers (e.g. PZ1..PZ8 and PS1.. PS7, respectively) which are connected to form a ring and in which in each case either a single logic one or a single logic zero is cyclically advanced,

   - in which the row clock signal and the column clock signal are formed in such a way that the clock ratio of row clock to column clock is greater than 1 divided by S and/or less than Z,

   - in which the row selection device (ZPTR) is advanced synchronously with the row clock signal (CLKZ) and

   - in which the column selection device (SPTR, SCH) is advanced synchronously with the column clock signal (CLKS).

3. Memory device according to Claim 2, in which both the row clock signal (CLKZ) and the column clock signal (CLKS) are identical to the external clock signal (CLK).

4. Memory device according to Claim 3,

   - in which the row selection device (ZPTR) and the column selection device (SPTR, SCH) are configured in such a way that a row change also always takes place simultaneously with each column change,

   - in which the number Z of rows and the number S of columns of the memory matrix (SM), the row jump increment (ZSW) and the column jump increment (SSW) satisfy the conditions

   $$GGT(S,SSW) = 1$$

   and

   $$GGT(Z, (S*ZSW) \bmod Z) = 1$$

   where GGT denotes the greatest common divisor and MOD denotes the modulo operation.

5. Memory device according to one or more of Claims 2 to 4,

in which the individual shift registers are assigned to the row lines and column lines in such a way that a desired row jump increment (ZSW) and a desired column jump increment (SSW) are thereby effected in the row and column selections.

## Revendications

1. Dispositif de mémoire à accès sériel,

   - comprenant une matrice (SM) de mémoire dont les lignes (11...ZS) de mémoire sont disposées en Z lignes et en S colonnes et sont reliées par des conducteurs (ZL) de lignes et par des conducteurs (SL) de colonne,
   - comprenant une unité (CLKV) de combinaison de cadence qui, à partir d'un signal (CLK) extérieur de cadence, forme un signal (CLKZ) de cadence de ligne et un signal (CLKS) de cadence de colonne,
   - comprenant un dispositif (ZPTR) de sélection de ligne, qui est relié aux conducteurs de ligne et qui, avec chaque signal (CLKZ) de cadence de ligne, avance cycliquement d'une largeur (ZSW) de saut de ligne prescrit dans la sélection des lignes,
   - comprenant un dispositif (SPTR, SCH) de sélection de colonne, qui est relié aux conducteurs de colonne et qui, avec chaque signal (CLKS) de cadence de colonne, avance cycliquement d'une largeur (SSW) de saut de colonne prescrite dans la sélection des colonnes,
   - dans lequel le dispositif de sélection des lignes et le dispositif de sélection des colonnes sont constitués de façon que respectivement une nouvelle ligne est sélectionnée, dès après que n colonnes ont été sélectionnées et/ou que respectivement une nouvelle colonne est sélectionnée dès après que m lignes ont été sélectionnées, n étant inférieur à S et m étant inférieur à Z et le nombre le plus grand, des deux nombres n et m, représentant le nombre des bits d'un mot de mémoire qui peut être corrigé encore par un code

2. Dispositif de mémoire suivant la revendication 1, dans lequel, tant le dispositif (ZPTR) de sélection de ligne que le dispositif (SPTR, SCH) de sélection de colonne ont un registre (par exemple PZ1..PZ8 et PS1..PS7) à décalage monté en un anneau, dans lesquels respectivement soit un un logique unique soit un zéro logique unique sont décalés cycliquement,

   - dans lequel le signal de cadence de ligne et le signal de colonne sont formés de façon que le rapport de la cadence de ligne à la cadence de colonne soit supérieur à S et/ou inférieur à Z,

- dans lequel le dispositif (ZPTR) de sélection de ligne avance en synchronisme avec le signal (CLKZ) de cadence de ligne,
- dans lequel le dispositif (SPTR, SCH) de sélection de colonne avance en synchronisme avec le signal (CLKS) de cadence de colonne.

3. Dispositif de mémoire suivant la revendication 2, dans lequel tant le signal (CLKZ) de cadence de ligne que le signal (CLKS) de cadence de colonne ont le même signal (CLK) extérieur de cadence.

4. Dispositif de mémoire suivant la revendication 3,

- dans lequel le dispositif (ZPTR) de sélection de ligne et le dispositif (SPTR, SCH) de sélection de colonne sont tels qu'avec chaque changement de colonne il s'effectue simultanément aussi toujours un changement de ligne,
- dans lequel le nombre Z de lignes et le nombre S de colonnes de la matrice (SM) de mémoire, la largeur (ZSW) de saut de ligne et la largeur (SSW) de saut de colonne satisfont les conditions,

$$GGT (S, SSW) = 1$$

et

$$GGT (Z, (S*ZSW) \; MOD \; Z) = 1$$

GGT étant le plus grand commun diviseur et MOD étant une opération modulo.

5. Dispositif de mémoire suivant l'une des revendications 2 à 4, dans lequel les divers registres à décalage des conducteurs de ligne et des conducteurs de colonne sont associés de façon à obtenir ainsi dans la sélection des lignes et des colonnes une largeur (ZSW) de saut de ligne souhaitée et une largeur (SSW) de colonne souhaitée.

FIG 1

EP 0 738 974 B1

## FIG 2

Z = 7 , S = 6 , ZSW = 1 , SSW = 1 , FB = 2

## FIG 3

Z = 4 , S = 5 , ZSW = 1 , SSW = 1 , FB = 1

# FIG 4

Z = 8 , S = 7 , ZSW = 3 , SSW = 2 , FB = 1

# FIG 5

Z = 8 , ZSW = 3

# FIG 6

S = 7 , SSW = 2